# EUROPEAN PATENT APPLICATION

(11) **EP 4 600 576 A1**
(43) Date of publication of application: **13.08.2025**
(21) Application number: 25154859.0
(22) Date of filing: 30.01.2025
(51) Int. Cl.: F24F 13/078, H05K 5/00

(54) **AIR-CONTAINMENT SYSTEM BEAM**

(30) Priority: 08.02.2024 CN 202410179006; 22.01.2025 US 202519034072
(71) Applicant: Schneider Electric IT Corporation, Foxboro, MA 02035 (US)
(72) Inventor: JIA, WenJuan, SHANGHAI, 201203 (CN); XIE, Yi, SHANGHAI, 201203 (CN)
(74) Representative: Plasseraud IP

(57) **Abstract**

An air-containment system beam includes a body having a first channel configured to receive a beam connector, a second channel configured to receive an air-containment panel, a third channel configured to receive at least one of a cabinet seal or a ceiling seal, and a fourth channel configured to receive at least one of a cabinet support or a ceiling panel support. The air-containment system beam further may include a fifth channel configured to receive at least one lighting support.

## Description

### BACKGROUND OF THE INVENTION

### 1. Field of the Invention

The present disclosure relates to air-containment systems, and more particularly to a data center air-containment system beam that is configured to support a variety of components.

### 2. Discussion of Related Art

To control the flow of air throughout a data center, and to guide the airflow through equipment racks provided in the data center, it may be desirable to contain the air in aisles to conserve energy and to lower cooling cost by managing airflow. As a result, air-containment systems have been developed to contain and manage air within the data center. The prevailing structures and methods for air-containment within data centers are limited to containment structures that are self-supporting or supported by other data center equipment, e.g., equipment racks.

In some freestanding air-containment system, fully configured IT equipment racks can be deployed or removed from the system, as necessary. This type of freestanding air-containment system is difficult to customize to meet various customer demands.

Another type of air-containment system includes a barrier between the hot exhaust and cold intake air streams in the IT environment. The separation of the hot and cold air streams in the IT environment increases the efficiency and effectiveness of the cooling system that supports the critical IT equipment. The separation also allows for an elevated supply-air temperature to be provided by the cooling system since the mixing of hot and cold air is eliminated. This type of system is compatible with row, room, or external cooling solutions and available for cold or hot aisle containment.

Another type of air-containment system includes structural ceilings used to hang components of the air-containment system. Such structural ceilings are prefabricated and offer limited flexibility in design and arrangement.

### SUMMARY OF THE INVENTION

One aspect of the present disclosure is directed to an air-containment system beam as defined in the appended claims.

Another aspect of the present disclosure is directed to a method as defined in the appended claims.

The present disclosure will be more fully understood after a review of the following figures, detailed description and claims.

### BRIEF DESCRIPTION OF THE DRAWINGS

In the drawings, each identical or nearly identical component that is illustrated in various figures is represented by a like numeral. For purposes of clarity, not every component may be labeled in every drawing. For a better understanding of the present disclosure, reference is made to the figures which are incorporated herein by reference and in which:
FIG. 1 is a perspective view of an air-containment system beam of an embodiment of the present disclosure;
FIG. 2 is a cross-sectional view of the beam shown in FIG. 1;
FIG. 3 is a perspective cross-sectional view of an air-containment system beam of another embodiment of the present disclosure, the beam being shown supporting components of an air-containment system;
FIG. 4 is a cross-sectional view of the beam shown in FIG. 3;
FIG. 5 is a perspective view of a mounting rail connector of an embodiment of the present disclosure;
FIG. 6 is a side view of a ceiling seal of an embodiment of the present disclosure;
FIG. 7 is a side view of a cabinet seal of an embodiment of the present disclosure;
FIG. 8 is a perspective view of a multi-wall panel of an embodiment of the present disclosure;
FIG. 9 is a cross-sectional view of a panel connector of an embodiment of the present disclosure;
FIG. 10 is a cross-sectional view of a mounting rail of an embodiment of the present disclosure;
FIG. 11 is a cross-sectional view of a lighting mounting rail of an embodiment of the present disclosure;
FIG. 12 is a perspective view of a light emitting diode (LED) module of an embodiment of the present disclosure;
FIG. 13 is a perspective view of a portion of an air-containment system showing corner brackets used to secure adjacent beams at a corner of the air-containment system of an embodiment of the present disclosure;
FIG. 14 is another perspective view of the portion of the air-containment system shown in FIG. 13;
FIG. 15 is a perspective view of connectors used to connect butt ends of adjacently placed beams of an embodiment of the present disclosure;
FIG. 16 is a perspective view of a tool used to secure a corner bracket to a beam of an embodiment of the present disclosure; and
FIGS. 17-22 are perspective views showing exemplary configurations of air-containment systems embodiments of the present disclosure.

### DETAILED DESCRIPTION

For the purposes of illustration only, and not to limit the generality, the present disclosure will now be described in detail with reference to the accompanying figures. This disclosure is not limited in its application to the details of construction and the arrangement of components set forth in the following description or illustrated in the drawings. The disclosure is capable of other embodiments and of being practiced or being carried out in various ways. Also the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items.

A data center may be designed to house a number of equipment racks, which are designed to house electronic equipment including but not limited to data processing, networking and telecommunications equipment. Each equipment rack may be configured to include a frame or housing adapted to support the electronic equipment. The housing includes a front, a back, opposite sides, a bottom and a top. Such orientations should be understood in relation to an upright positioning of an equipment rack during use, being submitted to gravity. The front of each equipment rack may include a front door so as to enable access into the interior of the equipment rack. The sides of the equipment rack may include one or more panels to enclose the interior region of the rack. The back of the equipment rack may also include one or more panels or a back door to provide access to the interior of the equipment rack from the back of the rack. In certain embodiments, the side and back panels, as well as the front door and the rear door, may be fabricated from perforated sheet metal, for example, to allow air to flow into and out of the interior region of the equipment rack. In other embodiments, the front door may include a removable panel.

The equipment racks are modular in construction and configured to be rolled into and out of position, e.g., within a row of the data center. Once in position, electronic equipment may be positioned in the interior region of the equipment rack. For example, the equipment may be placed on shelving secured within the interior region of the equipment rack. Cables providing electrical and data communication may be provided through the top of the equipment rack either through a cover (or "roof') at the top of the equipment rack having openings formed therein or through an open top of the equipment rack.

Data centers may be configured with rows of equipment racks arranged such that cool air is drawn into the racks from a cool aisle and warm or hot air is exhausted from the racks into a hot aisle. In one embodiment, the equipment racks may be arranged in two rows with the fronts of the equipment racks in a near row being arranged in a forward direction and the backs of the equipment racks in a far row being arranged in a rearward direction. However, as stated above, in a data center, there may be multiple rows of equipment racks in which the rows may be arranged with the fronts of the equipment racks facing one another to define the cold aisle and with the backs of the equipment racks facing one another to define the hot aisle. In other configurations, the hot or cold aisle may be disposed between a wall and a row of equipment racks. For example, a row of equipment racks may be spaced from a wall with the backs of the equipment racks facing the wall to define a hot aisle between the wall and the row of equipment racks.

To address the heat build-up and hot spots within the data center or equipment room, and to address climate control issues within the data center or room in general, a cooling system may be provided. In one configuration, the cooling system may be provided as part of the data center infrastructure. In another configuration, the data center's cooling system may be supplemented with the CRAC and/or CRAH. With yet another configuration, a modular cooling system may be provided in which modular cooling racks are interspersed within the rows of equipment racks.

In one embodiment, a management system may be provided to monitor and display conditions of the equipment racks, including the cooling racks. The management system may operate independently to control the operation of the equipment and cooling racks, and may be configured to communicate with a higher level network manager or with a management system associated with the data center. In certain circumstances, it may be desirable control the airflow within the hot and cold aisles, and in the hot aisles in particular. In some cases, heat generated from electronic components housed within the equipment racks is exhausted out of the backs of the equipment racks into the hot aisles. It may be desirable to contain the hot air for conditioning by a cooling unit, such as the modular cooling unit described above.

At least some embodiments of the present disclosure are directed to an air-containment system including a frame structure that is easy to assemble and provides a single, integrated unit that encloses the aisle while facilitating the conveyance of cooling, electrical, and communication/networking equipment. In one embodiment, the air-containment system includes a frame structure having end frames and cross frames that can be easily assembled without the use of tools. The air-containment system further includes cantilevered arms that support equipment, including cable trays specifically designed to support cables. The air-containment system further includes an air duct support that is integrated with roof or ceiling panels.

Embodiments of the present disclosure are directed to a beam used to fabricate an air-containment system. The beam can be used to mount an air-containment system of IT equipment racks or to hang from a ceiling support structure, with flexible transmission between a horizontal roof and a vertical duct. In some embodiments, the beam is fabricated from extruded polyvinylchloride (PVC) material, which can be cut onsite to desired lengths as needed. The beam, along with associated panels and accessories, can be used to create other types of containment.

In some embodiments, the beam is designed to simplify and reduce the time and cost of installing the air-containment system.

In some embodiments, the beam can be used with one or more corner connectors to create a frame of the air-containment system. Such a corner connector can be secured in place with screw fasteners by a tool, such as a hex wrench.

In some embodiments, the beam enhances the ability to design and fit the air-containment system around obstructions.

In some embodiments, the other accessories, such as panels, seals, hanging kits and rack support kits, can be used with the beam to create and construction many kinds of horizontal and vertical air-containment structures.

In some embodiments, the beam has a beam axis. In cases whereby the beam is formed by extrusion, the beam axis is parallel to a direction of extrusion.

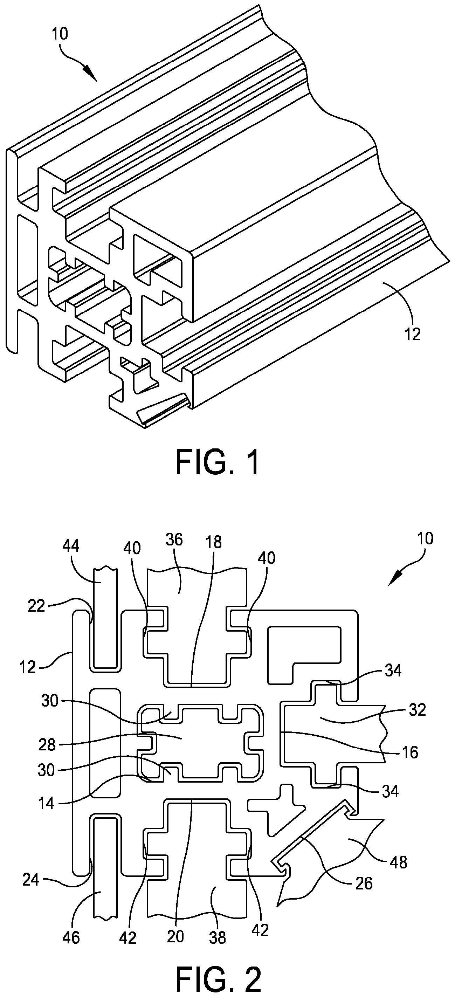

Referring now to the drawings, and more particularly to FIGS. 1 and 2, an air-containment system beam, sometimes simply referred to herein as a beam, is generally indicated at 10. In one embodiment, the beam 10 is fabricated from extruded plastic material, such as PVC, and is used to support components of an air-containment system. Extruded plastic materials other than PVC may be used. Specifically, the beam 10 is designed to include several discrete channels, each being provided to releasably secure and support a particular component. In some embodiments, the channels are channels along a direction generally parallel to the beam axis. The beam 10 is designed to provide flexibility to the person designing the air-containment system. Since the beam 10 is fabricated from plastic material, an installer can easily cut the beam to a desired length during installation on location. A skill saw or other type of saw can be used by the person installing the air-containment system to cut the beam to a desired length. In some embodiments, such cutting is along a plane perpendicular to the beam axis, the length of the beam being along the beam axis.

In one embodiment, the beam 10 includes a body 12 having several individual channels, each provided for a specific purpose. In the shown embodiment, the body 12 of the beam 10 includes a first channel 14, a second channel 16, two third channels 18, 20, two fourth channels 22, 24, and a fifth channel 26. The first channel 14 is formed centrally within the body 12 along the length of the body. The first channel 14 is provided to receive a beam connector, such as beam connector 28, to secure an end of a first beam such as the beam 10 with an end of a second beam such as an adjacently placed beam. In some embodiments, adjacently placed beam share their beam axis as a common axis. In some embodiments, the beam axis of adjacently placed beams are perpendicular. The beam connector 28 used to secure the ends of the beams together is described below. The first channel 14 defines a cavity or recess through which a body of the beam connector is secured thereby securing the adjacent beams to one another. As shown, the first channel 14 is a closed channel positioned within a middle or centrally of the body, and includes several inwardly extending flanges, each indicated at 30, which are used to engage and position the body of the beam connector.

A closed channel of a beam may in some embodiments be understood as a channel having a cross section entirely surrounded by the body of the beam, the cross section of the channel being in a plane perpendicular to an axis of the channel. In some embodiment, the axis of the channel is aligned with the beam axis.

In some embodiments, the body of a beam consists of a single, integral element.

The beam connector 28 can be configured to include a body having a cross section that is sized and shaped to fit within the opening formed by the first channel 14. The flanges 30 of the beam 10 are provided to engage an outer surface of the body of the beam connector 28. The arrangement is such that the body of the beam connector 28 can move axially within the opening of the first channel 14, with the flanges 30 preventing lateral movement of the beam 10 with respect to the beam connector. The beam connector 28 can be configured to connect and secure beams that are co-axial with respect to one another or perpendicular with respect to one another to form corners of the air-containment system.

The body 12 of the beam 10 further includes the second channel 16 formed along a side of the body. The second channel 16 is provided to receive a portion, such as panel portion 32, of an air-containment panel, which is described below. The second channel 16 defines a slot that is designed and configured to receive the panel portion 32 of the air-containment panel therein. The air-containment panel is provided to enclose the space defined by the air-containment system. The second channel 16 is an open channel positioned at the side of the body and includes two oppositely positioned open recesses, each indicated at 34, which are used to receive structural elements of the panel portion 32 of the air-containment panel to secure and support the panel portion (and the panel) to the beam 10.

An open channel of a beam may in some embodiments be understood as a channel having a cross section partially defined by the body of the beam, the cross section of the channel being in a plane perpendicular to an axis of the channel. In some embodiment, the axis of the channel is aligned with the beam axis.

The panel can be configured to include the panel portion 32, which are disposed on peripheral edges of the panel. Each panel portion 32 has a cross section that is sized and shaped to fit within the second channel 16. Specifically, the panel portion 32 includes features that are sized to fit within the recesses 34 formed in the second channel 16. The panel portion 32 extends from the panel, with the panel forming part of the air-containment system. The arrangement is such that the panel portion 32 of the panel can move axially within the second channel 16, with the features of the panel portion preventing lateral movement of the beam 10 with respect to the panel.

The body 12 of the beam 10 further includes the two third channels 18, 20, which are formed along a top and a bottom of the body, respectively. As shown, the third channel 18 is an upwardly facing open channel provided to receive a ceiling seal portion 36 of a ceiling seal. The third channel 20 is a downwardly facing open channel provided to receive a cabinet seal portion 38 of a cabinet seal. The third channels 18, 20 each define a slot that is designed and configured to receive its respective seal portion 36, 38 thereby creating an airtight seal to contain air within the air-containment system. Third channel 18 includes two oppositely positioned open recesses, each indicated at 40, which are used to receive the ceiling seal portion 36 of the ceiling seal to secure the ceiling seal in place. Similarly, third channel 20 includes two oppositely positioned open recesses, each indicated at 42, which are used to receive cabinet seal portion 38 of the cabinet seal to secure the cabinet seal in place. In some embodiments, the third channel includes at least one of an upwardly facing channel formed in the body and a downwardly facing channel formed in the body.

The ceiling seal can be configured to include the ceiling seal portion 36, which is configured to engage and releasably connect to the ceiling seal within the third channel 18. The ceiling seal portion 36 has a cross section that is sized and shaped to fit within the third channel 18. Specifically, the ceiling seal portion 36 includes features that are sized to fit within the recesses 40 formed in the third channel 18. In one embodiment, the ceiling seal forms an inverted U-shape seal that is designed to engage and seal a ceiling. The cabinet seal can be configured to include the cabinet seal portion 38, which is configured to engage and releasably connect to the cabinet seal within the third channel 20. The cabinet seal portion 38 has a cross section that is sized and shaped to fit within the third channel 20. Specifically, the cabinet seal portion 38 includes features that are sized to fit within the recesses 42 formed in the third channel 20. The cabinet seal forms a sheet or barrier for the air-containment system.

The body 12 of the beam 10 further includes the two fourth channels 22, 24 formed along a top and a bottom of the body, respectively. As shown, the fourth channels 22, 24 are located next to their respective third channels 18, 20, with the fourth channels 22, 24 being narrower than the third channels 18, 20. The fourth channel 22 is an open channel provided to receive a ceiling support 44. The fourth channel 24 is an open channel provided to receive a cabinet support 46. The fourth channels 22, 24 each define a slot that is designed and configured to receive its respective support 44, 46 thereby providing support to the ceiling and cabinet. In some embodiments, the fourth channel includes at least one of an upwardly facing channel formed in the body and a downwardly facing channel formed in the body.

The ceiling support 44 can be configured to include a body having a cross section that is sized and shaped to fit within the fourth channel 22. Similarly, the cabinet support 46 can be configured to include a body having a cross section that is sized and shaped to fit within the fourth channel 46.

The body 12 of the beam 10 further includes the fifth channel 26 formed at a corner of the body between the side of the body having the second channel 16 and the bottom of the body having the third channel 20. The purpose of the fifth channel is to support a lighting fixture to illuminate the interior of the air-containment system. The fifth channel 26 defines a slot that is designed and configured to receive a lighting support such as, for example, flange 48 or other type of support structure of the lighting fixture to releasably secure the lighting fixture in place. As shown, the fifth channel 26 is an open channel positioned at a corner of the body 12.

The lighting fixture can be configured to include the flange 48 and a light emitting diode (LED) module supported by the flange. As shown, the flange 48 has a cross section configured to be releasably secured within the fifth channel 26 of the body 12 of the beam 10. The LED module is provided to illuminate the interior of the air-containment system.

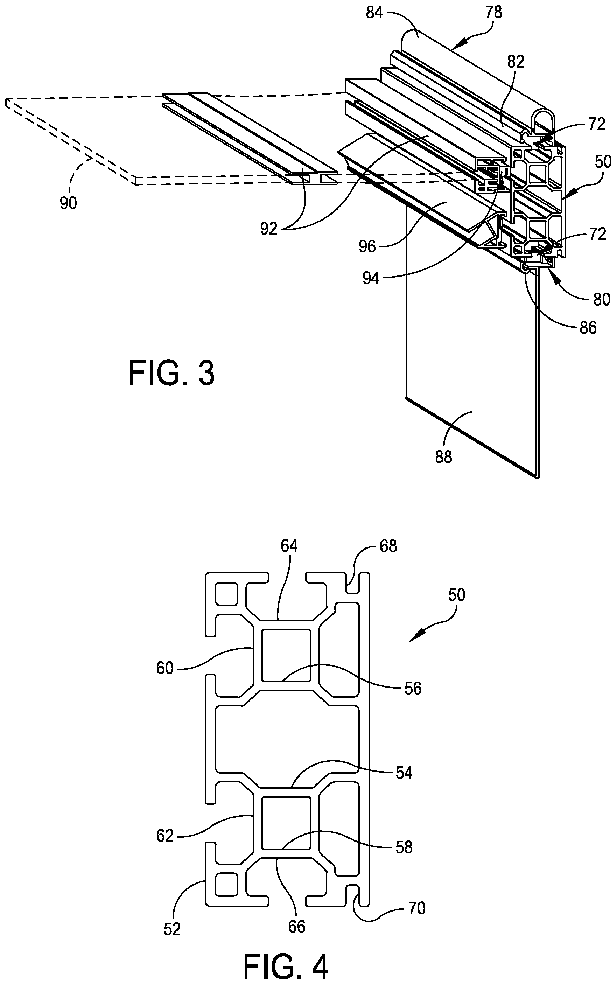

Referring to FIGS. 3 and 4, an air-containment system beam of another embodiment is generally indicated at 50. In the shown embodiment, as with beam 10, the beam 50 is fabricated from extruded plastic material and is used to support components of an air-containment system. The beam 50 is constructed similarly as beam 10 with the differences noted below. The beam 50 is designed to include several discrete channels, each being provided to support a particular component. The beam 50 is designed to provide flexibility to the person designing the air-containment system. Since the beam 50 is fabricated from plastic material, an installer can easily cut the beam to a desired length during installation.

In one embodiment, the beam 50 includes a body 52 having several individual channels, each provided for a specific purpose. In the shown embodiment, the body 52 of the beam 50 includes a main channel 54, two first channels 56, 58, two second channels 60, 62, two third channels 64, 66 and two fourth channels 68, 70. The main channel 54 provides structural integrity to the beam 50, and extends along a length of the beam. In this example, the main channel is a closed channel. As shown, the main channel 54 divides the beam 10 between an upper portion and a lower portion. A height of beam 50 is greater than a height of beam 10, with the main channel 54 providing added support and rigidity to the beam to enable the beam to support greater weights.

The body 52 of the upper portion of the beam 50 includes the first channel 56 formed within the body above the main channel 54 and along the length of the body of the beam. The first channel 56 is provided to receive a beam connector, similar to beam connector 28, to secure an end of the beam 50 with an end of an adjacently placed beam. The first channel 56 defines a cavity or recess through which a body of the beam connector is secured thereby securing the adjacent beams to one another. As shown, the first channel 56 is a closed channel, and can be sized to snugly fit the body of the beam connector.

The body 52 of the lower portion of the beam 50 further includes the first channel 58 formed within the body below the main channel 54 and along the length of the body of the beam. The first channel 58 is provided to receive a beam connector, similar to beam connector 28, to further secure an end of the beam 50 with an end of an adjacently placed beam. The first channel 58 defines a cavity or recess through which a body of the beam connector is secured thereby securing the adjacent beams to one another. As shown, the first channel 58 is a closed channel, and can be sized to snugly fit the body of the beam connector.

The body 52 of the upper portion of the beam 50 further includes the second channel 60 formed along a side of the body of the beam. The second channel 60 is provided to receive an air-containment panel, and defines a slot that is designed and configured to receive a flange or other type of support structure of the air-containment panel therein. The second channel 60 is an open channel positioned at the side of the body. Similarly, the body 52 of the lower portion of the beam 50 further includes the second channel 62 formed along a side of the body. The second channel 62 is provided to receive a lighting fixture to illuminate an interior of the air-containment system. The second channel 62 defines a slot that is designed and configured to receive a flange or other type of support structure of the air-containment panel therein. The second channel 62 is an open channel positioned at the side of the body 52 below the second channel 60.

The body 52 of the upper portion of the beam 50 further includes the third channel 64 formed along a top of the body of the beam. As shown, the third channel 64 is an upwardly facing open channel provided to receive a ceiling seal. Similarly, the body 52 of the lower portion of the beam 50 further includes the third channel 66 formed along a bottom of the body of the beam. As shown, the third channel 66 is a downwardly facing open channel provided to receive a cabinet seal. The third channels 64, 66 each define a slot that is designed and configured to receive its respective seal thereby creating an airtight seal to contain air within the air-containment system.

The body 52 of the upper portion of the beam 50 further includes the fourth channel 68 formed along a top of the body of the beam. As shown, the fourth channel 68 is located next to its respective third channel 64, with the fourth channel 68 being narrower than the third channel 64. The fourth channel 68 is an open channel provided to receive a ceiling support. Similarly, the body 52 of the lower portion of the beam 50 further includes the fourth channel 70 formed along a bottom of the body of the beam. As shown, the fourth channel 70 is located next to its respective third channel 66, with the fourth channel 70 being narrower than the third channel 66. The fourth channel 70 is an open channel provided to receive a cabinet support. The fourth channels 68, 70 each define a slot that is designed and configured to receive its respective support thereby providing support to the ceiling and cabinet.

As noted above with reference to the beam connector 28 used with beam 10, for each first channel 56, 58, a beam connector can be configured to include a body having a cross section that is sized and shaped to fit within the opening formed by the first channel 56, 58. The arrangement is such that the body of the beam connector can move axially within the opening of the first channel 56, 58, while preventing lateral movement of the beam connector with respect to the beam. The beam connector can be configured to connect and secure beams that are co-axial with respect to one another or perpendicular with respect to one another to form corners of the air-containment system.

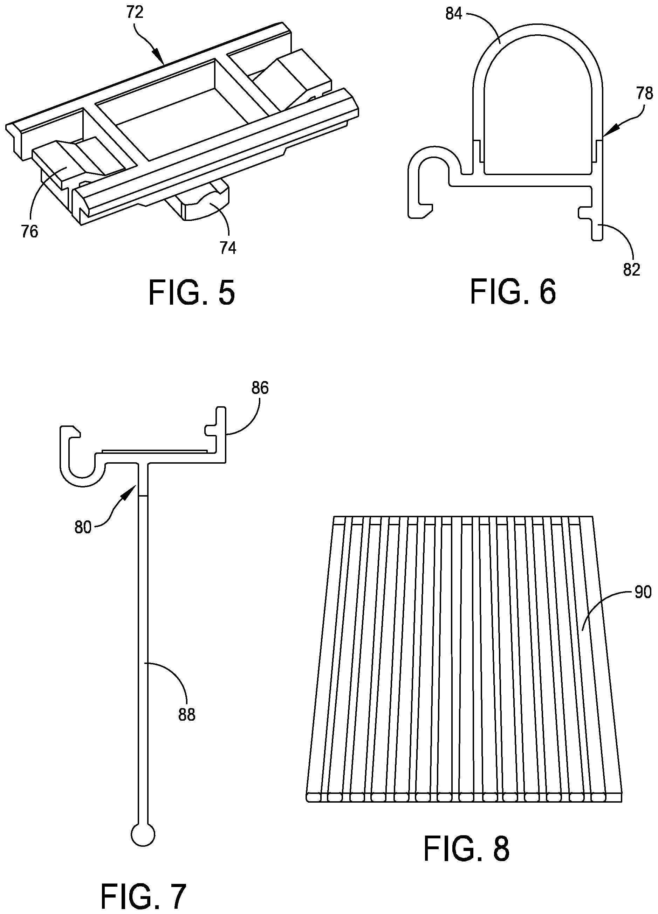

Referring to FIG. 5, a mounting rail connector is generally indicated at 72. As shown, the mounting rail connector 72 is shaped to fit within each of the second channels 60, 62 of the body 52 of the beam 50. The mounting rail connector 72 includes a flange portion 74 that is shaped and sized to fit within each of the second channels 60, 62 and a support portion 76 integrally formed with the flange portion. Specifically, the flange portion 74 of the mounting rail connector 72 has a cross section that is shaped and sized to fit within each of the second channels 60, 62 of the body 52 of the beam 50. The support portion 76 of the mounting rail connector 72 is configured to support components of the air-containment system. For each second channel 60, 62, the arrangement is such that the flange portion 74 can move axially within the second channel, while preventing lateral movement of the mounting rail connector 72 with respect to the body 52 of the beam 50.

For example, referring additionally to FIGS. 6 and 7, the mounting rail connector 72 is configured to support a ceiling seal (FIG. 6), generally indicated at 78, and a cabinet seal (FIG. 7), generally indicated at 80. As shown, the ceiling seal 78 includes a support structure 82 that is configured to engage and releasably connect to the mounting rail connector 72 on the third channel 64 and a seal 84 that is connected to the support structure. The seal 84 forms an inverted U-shape seal that is designed to engage and seal the beam 50 to a ceiling. Similarly, the cabinet seal 80 includes a support structure 86 that is configured to engage and releasably connect to the mounting rail connector 72 on the third channel 66 _ and a seal 88 that is connected to the support structure. The seal 88 forms a sheet or barrier for the air-containment system.

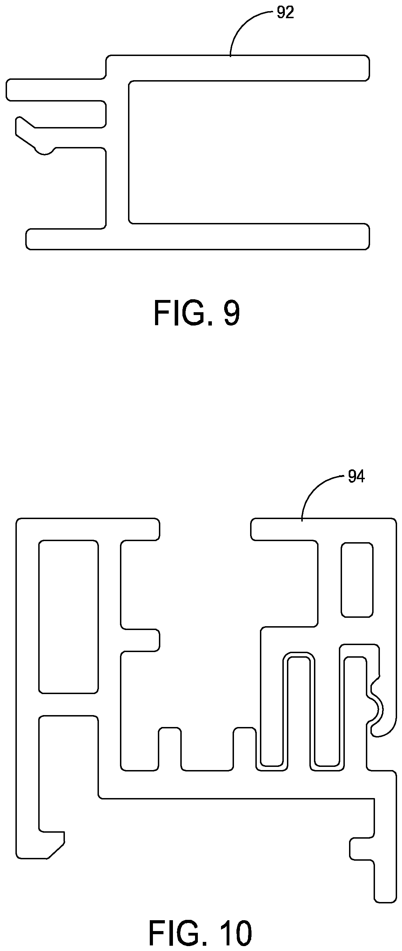

Referring to FIGS. 8-10, components of a panel connector assembly are shown. Specifically, FIG. 8 shows a multi-wall panel is indicated at 90, FIG. 9 shows a panel connector indicated at 92, and FIG. 10 shows a mounting rail indicated at 94. The multi-wall panel 90 can be used to form sides and the ceiling of the air-containment system. With reference to FIGS. 3 and 4, the panel connector 92 is configured to be releasably secured to the second channel 60 of the body 52 of the beam 50 and to the mounting rail 94. The purpose of the panel connector 92 is to secure the mounting rail 94 to the beam. Once secured, the mounting rail 94 is configured to releasably secure the multi-wall panel 90 at an edge of the multi-wall panel. In the shown embodiment, the multi-wall panel 90 is disposed horizontally; however, the beam 50 can be oriented in a manner in which the multi-wall panel is disposed vertically.

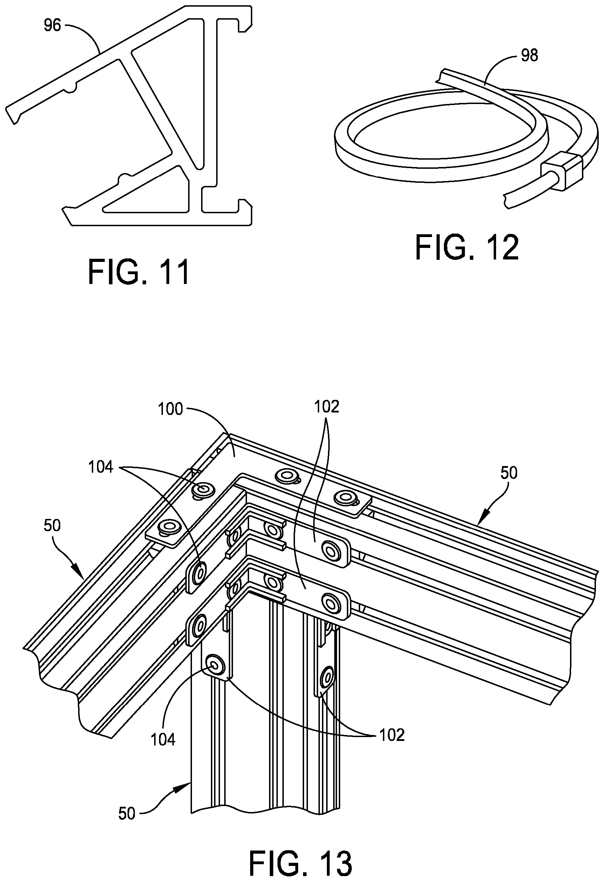

Referring to FIGS. 11 and 12, components of a lighting fixture assembly are shown. Specifically, FIG. 11 shows a lighting mounting rail indicated at 96 and FIG. 12 shows a light emitting diode (LED) module indicated at 98. With reference to FIG. 4, the lighting mounting rail 96 is configured to be releasably secured to the second channel 62 of the body 52 of the beam 50 and to the LED module 98 (lighting fixture). The LED module 98 is provided to illuminate an interior of the air-containment system, and may be connected to a suitable power source and to a switch to activate the LED module.

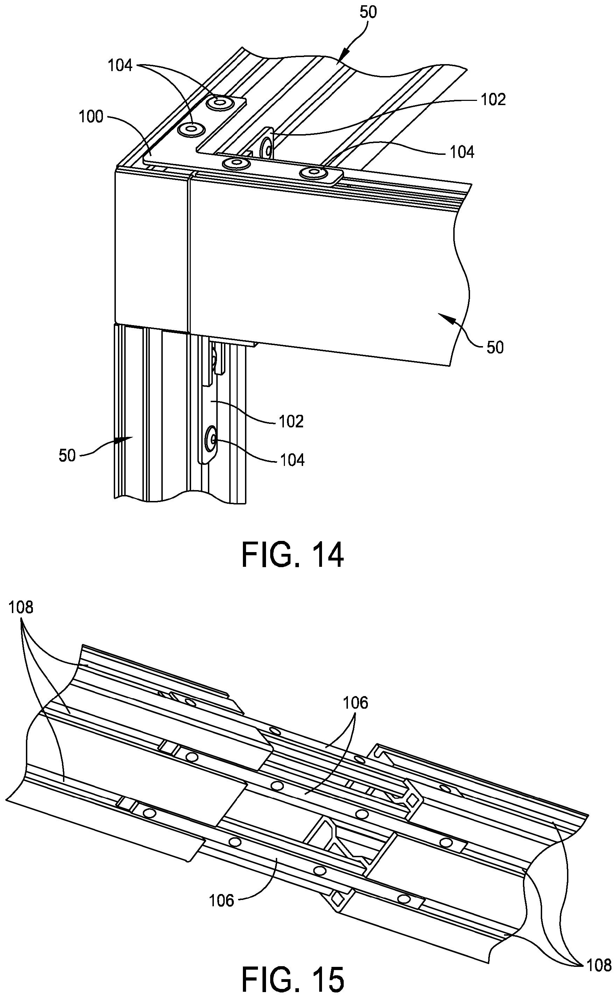

Referring to FIGS. 13 and 14, angled corner brackets or connectors 100, 102 are used to secure adjacent beams, e.g., beams 50, at a corner of the air-containment system. As shown, the air-containment system at a corner of the air-containment system includes a first type of L-shaped bracket 100 configured to engage an upper horizontal surfaces of the beams 50 forming the corner. The air-containment system at the corner further includes a second type of L-shaped bracket 102 configured to engage horizontal inner surfaces of the beams 50 forming the corner and configured to engage vertical and horizontal inner surfaces of the beams forming the corner. Screw fasteners, each indicated at 104, are used to secure the brackets 100, 102 to the beams 50. In one embodiment, the screw fastener 104 is a self-tapping screw.

Referring to FIG. 15, several connectors, each indicated at 106, are used to connect butt ends of adjacently placed beams 50. As shown, the butt ends of the beams 50 are spaced apart from one another, with each straight connector 106 being seated within a channel, each indicated at 108, formed in an outer surface of the beam. The arrangement is that the butt ends of the beams 50 are moved toward one another so as to engage one another, with the connectors 106 being secured to the beams by screw fasteners, such as self-tapping screws.

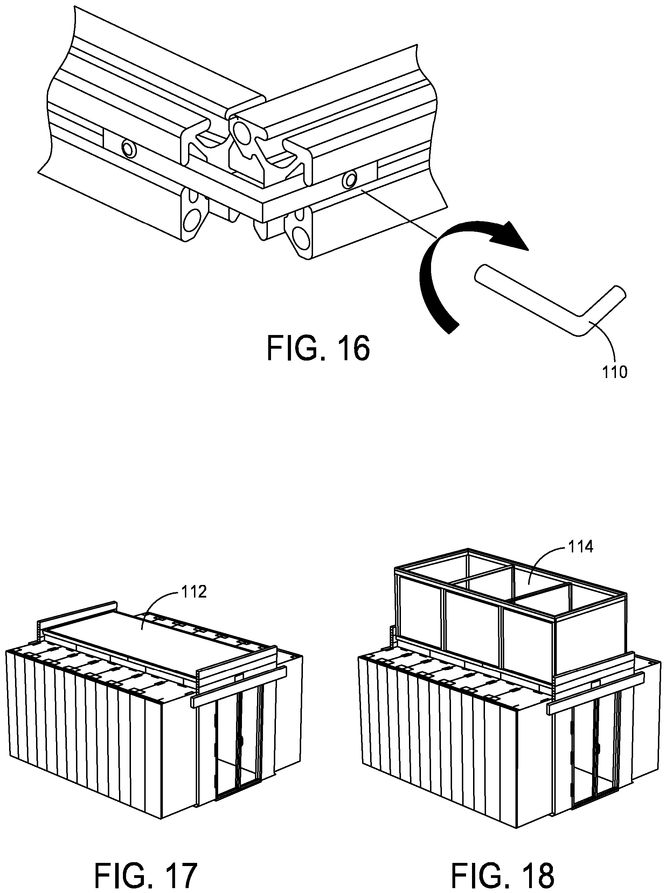

Referring to FIG. 16, a tool, such as Allen wrench 110, can be used to secure the brackets in place. Specifically, the Allen wrench 110 can be used to secure the screw fasteners used for the brackets 100, 102 and for the connector 106.

In some embodiments, a method of fabricating an air-containment system beam may include forming a first channel in an extruded body, the first channel being configured to receive a beam connector, forming a second channel in the body, the second channel being configured to receive an air-containment panel, forming two third channels in the body, the third channels being configured to receive a cabinet seal and a ceiling seal, and forming two fourth channels in the body, the fourth channels being configured to receive a cabinet support and a ceiling panel support. In one embodiment, the method further includes forming a fifth channel in the body, the fifth channel being configured to receive at least one lighting support fixture. The method can include an extrusion process of plastic material, such as PVC material.

In another embodiment, a method of fabricating an air-containment system beam may include forming a main channel in an extruded body, forming two first channels in the body, the first channels each being configured to receive a beam connector, forming two second channels in the body, the second channels being configured to receive an air-containment panel and a lighting support fixture, forming two third channels in the body, the third channels being configured to receive a cabinet seal and a ceiling seal, and forming two fourth channels in the body, the fourth channels being configured to receive a cabinet support and a ceiling panel support. As with the aforementioned method, the method can include an extrusion process of plastic material, such as PVC material.

In some embodiments, the methods hereby described permit fabricating a body of a beam consisting of a single, integral element.

A data center can be configured to have rows of equipment racks, with aisles being disposed between the rows of equipment racks. In one embodiment, a row of equipment racks is positioned so that the fronts of the equipment racks face outwardly and a second row of equipment racks may be positioned on an opposite side of the aisle so that the fronts of the equipment racks face outwardly and the backs of the equipment racks face the backs of the row of equipment racks. In certain embodiments, one or more equipment racks may be replaced by a cooling rack to provide cooling to the aisle.

In one embodiment, the rows of equipment racks can be arranged so that hot air is exhausted through the backs of the equipment racks into the aisle. Conversely, the rows of equipment racks can be arranged so that cold air is deposited into the aisle through one or more air duct systems. In another embodiment, air can be directed to escape the aisle above the equipment racks. Warm air rises, thus creating a situation in which the ceiling of the data center may become too warm. This situation may negatively affect the climate control within the data center. An air-containment system of an embodiment of the present disclosure is designed to control the flow of warm air within the data center, and within the space between the equipment racks. The air-containment system is further configured to efficiently accommodate cooling, electrical and communication/networking equipment.

In some embodiments, an air-containment system includes a frame structure having beams, such as beams 10, 50, which provide the main structural components of the air-containment system. As described, the air-containment system further includes connectors, closures, wall and ceiling panels and other accessories used to complete the air-containment system. Embodiments of the air-containment system enable equipment racks and other floor standing, rolling or otherwise transportable equipment to be rolled, inserted, or otherwise moved and removed into and out of the frame structure of the air-containment system, without being encumbered by piping, ductwork, raceways containing wires, cables, and other means of conveyance of electricity, thermal energy, data, and other transferable media, which shall be supported by the frame structure. In certain embodiments, the air-containment system can include means of conveyance that are specific to data center architecture, include electrical conduits, fire suppression pipes, chilled water pipes, "supply" and/or "return" air ducts and other similar guides, channels, or raceways, are intended to attached to the frame structure instead of the overhead structure of the building. For example, the frame structure may be modified to support chilled water pipes.

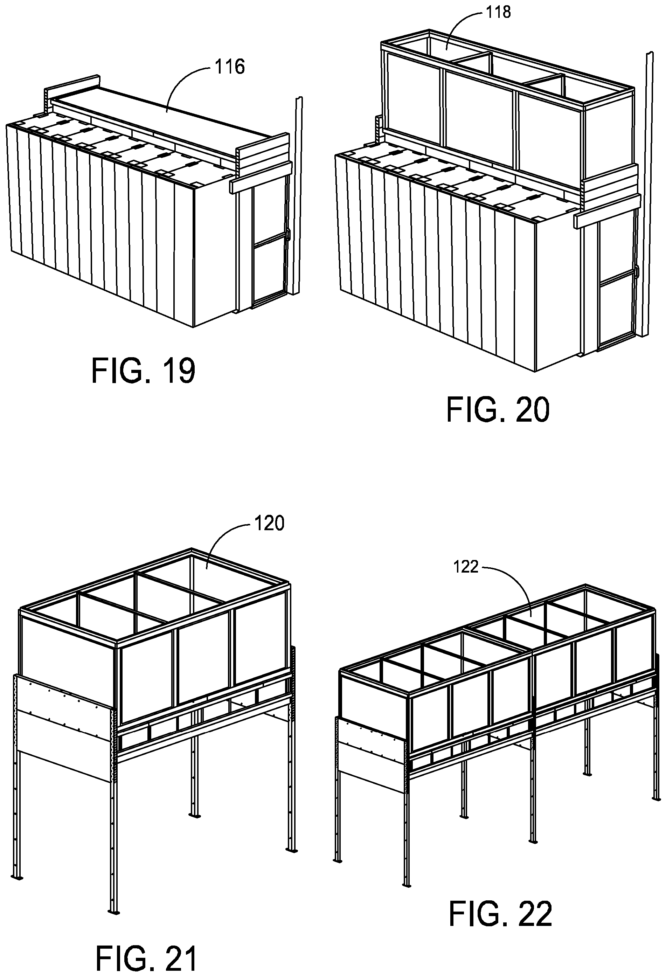

Referring to FIGS. 17-22, exemplary configurations of air-containment systems are shown. For example, FIG. 17 shows a low profile air-containment system 112 disposed over an aisle between two rows of equipment racks. FIG. 18 shows a higher profile air-containment system 114 disposed over an aisle between two rows of equipment racks. FIG. 19 shows a low profile air-containment system 116 disposed over an aisle between one row of equipment racks and a wall. FIG. 20 shows a high profile air-containment system 118 disposed over an aisle between one row of equipment racks and a wall. FIG. 21 shows a high profile air-containment system 120 supported by a structure configured to elevate the air-containment system. FIG. 22 shows another high profile air-containment system 122 supported by another type of structure configured to elevate the air-containment system. During installation, the beams are assembled with one another to create the desired configuration.

Having thus described at least one embodiment of the present disclosure, various alternations, modifications and improvements will readily occur to those skilled in the art. Such alterations, modifications and improvements are intended to be within the scope and spirit of the disclosure. Accordingly, the foregoing description is by way of example only and is not intended to be limiting. The disclosure's limit is defined only in the following claims and equivalents thereto.

## Claims

1. An air-containment system beam (10, 50), comprising:
a body (12, 52) including
a first channel (14, 56, 58) configured to receive a beam connector (28),
a second channel (16, 60) configured to receive an air-containment panel (32),
a third channel (18, 20, 64, 66) configured to receive at least one of a cabinet seal (38) or a ceiling seal (36), and
a fourth channel (22, 24, 68, 70) configured to receive at least one of a cabinet support (46) or a ceiling panel support (44).

2. The air-containment system beam of claim 1, further comprising a fifth channel (26) configured to receive at least one lighting support (48).

3. The air-containment system beam of claim 2, wherein the fifth channel is an open channel positioned at a corner of the body.

4. The air-containment system beam of any of the above claims, wherein the first channel is a closed channel positioned within a middle of the body.

5. The air-containment system beam of any of the above claims, wherein the second channel is an open channel positioned at a side of the body.

6. The air-containment system beam of any of the above claims, wherein the third channel includes at least one of an open channel positioned at a top and an open channel positioned at a bottom of the body.

7. The air-containment system beam of any of the above claims, wherein the fourth channel includes at least one of an open channel positioned at a top and an open channel positioned at a bottom of the body.

8. The air-containment system beam of any of the above claims, wherein the third channel includes at least one of an upwardly facing channel formed in the body and a downwardly facing channel formed in the body.

9. The air-containment system beam of any of the above claims, wherein the fourth channel includes at least one of an upwardly facing channel formed in the body and a downwardly facing channel formed in the body.

10. The air-containment system beam of any of the above claims, wherein the beam is fabricated from extruded PVC material.

11. The air-containment system beam of any of the above claims, further comprising the beam connector, the beam connector being configured to secure a first beam to a second beam.

12. The air-containment system beam of claim 11, wherein the connector includes a straight connector configured to connect mating ends of the first beam and the second beam along a common axis or an angled connector configured to connect mating ends of the first beam and the second beam, the second beam being perpendicular to the first beam.

13. An air-containment structure comprising the air-containment system beam of any of the above claims.

14. A method of fabricating an air-containment system beam, the method comprising:
forming a first channel in an extruded body, the first channel being configured to receive a beam connector;
forming a second channel in the body, the second channel being configured to receive an air-containment panel;
forming a third channel in the body, the third channel being configured to receive at least one of a cabinet seal or a ceiling seal; and
forming a fourth channel in the body, the fourth channel being configured to receive at least one of a cabinet support or a ceiling panel support.

15. The method of claim 14, wherein the air-containment system beam is according to any of the above claims 1 to 13.
